# EUROPEAN PATENT APPLICATION

(11) **EP 4 250 376 A1**
(43) Date of publication of application: **27.09.2023**
(21) Application number: 22164234.1
(22) Date of filing: 24.03.2022
(51) Int. Cl.: H01L 31/072, H01L 31/078, H01L 51/42

(54) **A SOLAR CELL AND METHOD OF FABRICATION THEREOF**

(71) Applicant: Brunner, Thomas Oliver, 70569 Stuttgart (DE)
(72) Inventor: Brunner, Thomas Oliver, 70569 Stuttgart (DE)
(74) Representative: Murgitroyd & Company

(57) **Abstract**

In one embodiment, the present disclosure provides a solar cell structure comprising: a first semiconductor layer (2) of a first dopant type in electrical communication with a first electrode (1); a second semiconductor layer (3) of a second dopant type in electrical communication with a second electrode (4); characterized in that between the first semiconductor layer (2) and second semiconductor layer (3) a transparent conductive layer (5) is positioned. Physically separating the semiconductor layers (2, 3) with a transparent conductive layer (5) has been found to decrease degradation and increase efficiency of the solar cell structure.

## Description

### Field of the Disclosure

The present disclosure relates generally to a solar cell and a fabrication method thereof and finds particular, although not exclusive, utility in providing an improved transparent, solar cell, which is preferably made of inorganic components.

### Background

Solar energy has many advantages when compared to other typical forms of energy. For example, solar energy is free and is accessible in even the most remote places. Furthermore, solar energy is accessible in space and other places that typical fuel sources are not available or are difficult to access. It is known to use solar cells to convert solar energy to electrical energy via the photovoltaic effect.

Prior known transparent solar cells typically include a stacked assembly of a plurality layers including a transparent electrically non-conductive substrate, such as glass. Most of known solar cells use crystalline silicone cells or thin-film cells. Conventional silicon solar cells consist of metal contacts such as several conductive finger paths on the front cell side to form a front electrode. Between the front electrode, which may be configured as a negative electrode, and a back electrode, which may be configured as a positive electrode, a first semiconductor layer of a first dopant type and a second semiconductor layer of a second dopant type are provided. Photons impinging on the solar cell cause electrons to be passed from one semiconductor layer to the other and this flow of electrons may be collected and used to power electronic equipment or charge batteries.

Further, it is known from common transparent solar cells that the rear side of the solar cell has not only the function of a back electrode but also to optically reflect. An example for such solar cell is disclosed in DE 10 2009 024 050 A1, wherein a stacked assembly including a plurality of layers is provided having a transparent substrate, a transparent front electrode and back electrode with a photovoltaic active layer system in-between and an electrically non-conductive reflector on the back side.

Common photovoltaic devices consist of a plurality of semiconductor or other solid-state components formed in or on a common substrate and are sensitive to infra-red radiation, light, electromagnetic radiation of shorter wavelength and adapted for the conversion of the energy of such radiation into electrical energy. Conventionally each module is rated by its direct current (DC) output or voltage output under standard test conditions (STC). Usually the modules come with a 25-year service life, but there is a midlife-failure as well as significant failure in the long-term performance. Solar cells made of silicon typically have an efficiency of 20 %. So 20 % of the solar energy will be transformed in electrical energy. Because of degradation effects, the performance or efficiency of solar cells lowers over time. The average loss in efficiency or performance of solar cells currently in use is less than 20 % for 20-25 years. For photovoltaic solar modules some manufacturers guarantee for the first 10 years an efficiency or a performance of about 90 % is disclosed. This value is derived from an assumption that there is a continuous degradation of about 0,5 % per year, which would result in 95 % efficiency or performance after 10 years. Solar cells degrade over time and reduce in efficiency. Since currently obtained efficiencies are quite low, it is desirable to reduce the degradation and increase especially the long-term efficiency of solar cells.

The inventor assumes that the degradation of a solar cell is at least partially due to the fact that over time the relatively flat boundary layer between the n- and p-doped semiconductor layers changes such that after extended use microscopic "peaks" and "valleys" form. In the worst scenario break-ins arise. A homogeneous layer of the same overall thickness of the n-doped semiconductor is therefore no longer given. In areas with valleys or break-ins of the n-doped semiconductor layer, fewer electrons flow and the efficiency of the solar cell decreases. It is an object of the present invention to slow down this process and thus reduce the degradation rate. It is an object of the present invention to maintain a homogenous layer of a predetermined overall thickness of each semiconductor layer without any irregularities over the lifetime of the solar cell.

One object of the present disclosure is to provide a solar cell with a decreased degradation rate and an increased efficiency over previously known devices of the same size i.e. increase a better power conversion efficiency than common solar cells.

### Summary

According to a first aspect of the present disclosure, there is provided a solar cell structure comprising: a first semiconductor layer of a first dopant type in electrical communication with a first electrode; a second semiconductor layer of a second dopant type in electrical communication with a second electrode; characterized in that between the first semiconductor layer and second semiconductor layer a transparent conductive layer is positioned. The solar cell may be transparent and/or inorganic. Further at least partially organic materials can be used. The solar cell may alternatively be called a photovoltaic cell.

The inventor found that a reduced degradation rate and an increased efficiency may be obtained by physically separating the first and second semiconductor layers with the transparent conductive layer. As such, a more desirable solar cell yielding a higher efficiency may be provided.

The inventor assumes that the degradation of a solar cell without the inventive separating layer may at least partially be a result of a change of the microscopic structure of the interface or boundary layer. The initial boundary layer between n-type and p-type semiconductor layers are overall even and it is assumed that in operation this even interface becomes uneven or irregular over the time. That is to say microscopic valleys and mountains may be built up and there would be no more an overall homogenous thickness of the n-type semiconductor. Further, the inventor assumes that the unevenly distributed areas of thinner and thicker n-type semiconductor result in a inhomogenous electron flow in the semiconductor material and the efficiency of the solar cell would degrade. However, this potential degradation mechanism would be avoided or at least slowed down by the provision of the transparent conductive layer between the first and second semiconductor layers, thereby increasing the efficiency and lifetime of the solar cell structure.

The transparent conductive layer may physically separate the boundary layer between the two semiconductor layers. Accordingly, the first and second semiconductor layers may not be in contact with each other at any point.

The first and/or second electrode may comprise conductive tracks, rails or fingers. The tracks, rails or fingers may extend across the entire width and/or depth of the respective semiconductor layer. When the first electrode comprises tracks, rails or fingers, the solar cell may be arranged, in use, such that the first electrode is sun facing and at least a portion of the first semiconductor layer is exposed to sunlight. Accordingly, photons may impinge on the first semiconductor layer between the tracks, rails or fingers. The first electrode may also be made of transparent material such that the photons may pass through the conductive tracks, paths or fingers. In alternative embodiments, the first and/or second electrode may comprise a conductive mesh or a nanomesh.

In some embodiments, the transparent conductive layer is configured such that 20 % to 100 % of the incoming photons pass through said conductive layer. Optical transparency may be achieved when at least 20 % of photons pass through the respective structure. In alternative embodiments, the transparent conductive layer is configured such that 25 % to 100 %, 30 % to 100 %, 35 % to 100 %, 40 % to 100 %, 45 % to 100 % or 50 % to 100 % of the incoming photons pass through said conductive layer. Greater performance may be achieved by providing a relatively more optically transparent conductive layer between the first and second semiconductor layers.

In some embodiments, the conductive layer has a conductivity of at least 10 000 S/m. It has been found that providing a conductive layer with a conductivity of at least 10 000 S/m produces a solar cell with desirable efficiency and degradation properties. In alternative embodiments, the conductive layer has a conductivity of at least 11 000, 12 000, 13 000, 14 000, 15 000, 20 000, 25 000 or 30 000 S/m. Greater performance may be achieved by providing a relatively more conductive layer.

By providing solar cells with said conductive layers the potential to achieve higher power conversion efficiencies (PCE) is significantly increased. At the same time the degradation rate is decreased.

In some embodiments, the, or each, conductive layer comprises one or more of the following materials selected from the group comprising: Ag, Cu, Au, Al, W, Fe, Fe/C, conductive metal grids, metal nanowires graphite, graphene, carbon nanotubes, conductive polymers, preferably poly (3,4.ethylenedioxythipene) poly (styrenesulfonate) (PEDOT-PSS), conductive adhesives and conductive fluids and/or combination thereof. In some embodiments, the, or each, transparent conductive layer comprises a conductive material embedded in a polymer.

Said metals or alloys made of a combination of two or more metals as well as other listed materials are characterized by an excellent electric conductivity. Said fluid having conductive properties may be a synthetic resin in accordance with DIN EN ISO 4618 and after being solidified they still keep the conductive function. Using such conductive fluid has the advantage that it easy to manipulate in the liquid state and once the resin is cured the bonding to the adjacent layers is advantageously characterized by high bond strengths.

In some embodiments, the overall thickness of the conductive layer is at least 3 µm. A conductive layer with a thickness of at least 3 µm has been found to provide more advantageous and desirable properties when compared to conductive layers with a thickness of less than 3 µm. In alternative embodiments, the overall thickness of the conductive layer is at least 5 µm, 10 µm, 25 µm, 50 µm, 100 µm, 200 µm, 250 µm or 500 µm. Other thicknesses may be advantageous depending on the use case and the semiconductor materials used. In some embodiments, the thickness range is selected from the group comprising: 3-5 µm, 5-100 µm, 100-500 µm and 500 µm to 6000 µm. Alternative start and end values for the ranges are envisaged, such as the thickness values disclosed herein.

With a thicker conductive layer, the distance between the electron donor and acceptor is increased and a stronger electric field establishes between the two layers. It is assumed that the efficiency is advantageously increased because the associated reduction in efficiency due to the absence of a separating layer is avoided. Furthermore, by providing a thickness of at least 20 µm, preferably 25 µm, or more the same time overheating is decreased, such that a relatively high degree of efficiency is given even at high operating temperatures.

In some embodiments, the solar cell structure further comprises at least a further transparent conductive layer between the first electrode and the first semiconductor layer and/or a further conductive layer between the second electrode and the second semiconductor layer. In some embodiments, the solar cell structure comprises a first further transparent conductive layer between the first electrode and the first semiconductor layer, and a second further transparent conductive layer between the second electrode and the second semiconductor layer. As such, the solar cell may comprise three transparent conductive layers, which has been found to provide particularly beneficial and advantageous efficiency and degradation properties.

In some embodiments, the transparent conductive layer is a sandwich structure or functional thin layer made of a functional conductive layer supported by a carrier substrate made of glass, wafer or film. The term "carrier substrate" includes or extends only to layers that do not perform a conductive function in the operation of the solar cell structure, but are provided solely to carry the functional conductive layer and optionally to adhere the functional conductive layer to the adjacent semiconductor layer. The carrier substrate may be transparent or translucent.

In preferred embodiments, the solar cell is made of inorganic materials. Alternatively, hybrid solar cells combining organic and inorganic materials with the aim of utilising the low cost cell production of organic photovoltaics (OPV) as well as obtaining other advantages from the inorganic component, such as tuneable absorption spectra can be envisaged.

In some embodiments, the first and/or second semiconductor layers are made of inorganic materials selected from of the group comprising: armorphous silicone (aSi); polycrystalline silicon; monocrystalline silicone; perovskite, cadmium telluride (CdTe); copper indium gallium selenide (CIGS); and an III-V semiconductor. An III-V semiconductor may be an alloy containing elements from groups III and V in the periodic table, such as gallium arsenide, indium nitride, aluminium gallium arsenide, indium gallium phosphide or indium gallium nitride. It is noted that the first and second semiconductor layers can be of the same material or be of two different materials. For instance if the lower layer is a silicone other material can be deposited thereon. In alternative embodiments, the semiconductor material may be cadmium selenide, cadmium sulphide, zinc telluride, copper sulphide, tin(II) sulphide, iron disulphide, copper tin sulphate, cadmium zinc telluride, an alloy containing any semiconductor material listed herein, and/or any other semiconductor material known in the art.

In particular, a material that is frequently used for the n-doped layer (electron donor) is perovskite. This material enables a very thin layer, which can be only 500 nm thick, and can absorb the entire visible spectrum of sunlight. A conventional silicon layer which has been doped with boron is often used for the p-doped layer (electron acceptor). Solar cells made from perovskite are also known as PSC (perovskite solar cell). Such perovskite solar cells may be built as tandem-junction solar cells that are built of two single-junction solar cells. A PSC may be built by depositing perovskite directly onto a silicon solar cell in a tandem stack. Other combinations than perovskite with silicon can be envisaged.

In order to further improve efficiency compared to a stacking of two single junction solar cells a triple junction solar cell can be manufactured with at least first and second solar cell stacked on top of a third solar cell. That is to say, it can be envisaged to design a multi-junction solar cell, wherein on top of a second solar cell at least a further solar cell is arranged. Thus, the multi-junction solar cell comprises a plurality of single junction solar cells comprising three or more of said solar cells. Such multi-junction cells have the advantage of a higher power conversion efficiency. Each solar cell of a multi-junction solar cell can be of the same kind or have distinct kinds of semiconductor compounds. The latter alternative means that a multi-junction cell can be designed by layering different materials on top of each other.

An advantage to use multi-junction cells with distinct materials of the stacked layers is that each layer can have a distinct function than the adjacent layer. In this way a single unit formed of a plurality of cells can provide multiple bandgaps compared to a single junction solar cell. More particularly, a multi-junction cell can respond to multiple light wavelengths and the loss of photons above and below a band gap energy can be avoided. A preferred embodiment of a multi-junction cell, has a top layer that absorbs light of the shortest wavelengths (biggest bandgap) and increasing wavelengths through the body of the cell. In this way, the spectrum of the sun can be optimally used.

If tandem or other multi-junction solar cells technologies are based on crystalline silicon as lowermost cell they have the advantage that these silicon based cells are based on a well-known technology. Double or multi- junction solar cells with silicon subcells may have nanotextured silicon to further improve the electronic quality of the multi- solar cell.

In some embodiments, the first dopant type of the semiconductor layer is a n-type and the second dopant type of the second semiconductor layer is a p-type. The first semiconductor layer may be an electron donor and the second semiconductor layer may be an electron acceptor. Electrons may flow from the first semiconductor layer to the second semiconductor layer via the transparent conductive layer. The first electrode may be a negative electrode and the second electrode may be a positive electrode.

In some embodiments, the solar cell and the conductive layer of the solar cell structure are made of a flexible material. As example of flexible solar cells organic solar cells can be named. In this way the solar cell is in particular suited to be used for placing on curved or otherwise non-planar sub-surfaces such as an automobile roof, curved roof-tops of buildings or an aircraft hull. Furthermore, it is advantageous that flexible solar cells are typically lightweight. This is especially advantageous if the solar cell with the conductive layer is used in the construction of aircraft components or on rooftops in buildings that need to limit the overall weight. Furthermore, individuals as outdoor workers or persons being often exposed to sunlight can profit of the use of such flexible solar cells in clothing articles or backpacks.

According to a second aspect of the present disclosure, there is provided a method of producing a solar cell comprising the steps of: providing a first electrode; preparing a semiconductor layer of a first dopant type in electrical communication with the first electrode; providing a transparent conductive layer on the surface of the first semiconductor layer, wherein the method of forming the conductive layer is selected from the group of additive processes comprising: CVD, PVD, a galvanic procedure or a sol-gel process; and forming a second semiconductor layer of a second dopant type on the transparent conductive layer; and electrically connecting the second semiconductor layer with a second electrode. In this way, the solar cell according to the first aspect of the present disclosure may be produced.

CVD is an acronym of Chemical Vapour Deposition, as is well known in the art. PVD is an acronym of physical vapour deposition, as is well known in the art.

The attaching of the transparent conductive layer with the components of the solar cell structure can be realized using standard attachment methods according to DIN 8593.

In some embodiments, between the first electrode and the first semiconductor layer a further transparent conductive layer is formed. In some embodiments, between the second electrode and the second semiconductor layer a further transparent conductive layer is formed. Providing transparent conductive layers between an electrode and the adjacent semiconductor layer has been found to provide increased efficiency and improved degradation properties. It is advantageous that especially the transparent conductive layer between the first semiconductor layer and the second semiconductor layer increase the overall lifetime of the solar cell structure.

In some embodiments, the at least one transparent conductive layer is produced by embedding conductive material in a polymer, wherein the conductive material is selected from the group comprising: Ag, Cu, Au, Al, W, Fe, Fe/C, conductive metal grids, metal nanowires, graphite, graphene, carbon nanotubes and/or combination thereof.

If for example nanowires are used, the thickness of the transparent conductive layer may depend on the thickness of the nanowires, which may have a diameter of 1 nm to 100 nm, preferably 10 nm to 75 nm. Alternatively, carbon nanotubes can be used which have similarly to the metal grids or nanowires a very high conductivity.

In some embodiments, at least one transparent conductive layer is made of a functional conductive layer supported by a carrier substrate made of glass, wafer or film. As discussed previously, the term "carrier substrate" includes or extends only to layers that do not perform a conductive function in the operation of the solar cell structure, but is provided solely to carry the functional conductive layer and optionally to adhere the functional conductive layer to the adjacent semiconductor layer. The carrier substrate may be transparent or translucent.

It is to be understood, that the second aspect of the present disclosure may include any or each of the features described with regard to the first aspect. The necessary production, provision and/or assembly is envisaged. Additionally, it is to be understood that the first aspect of the present disclosure may include any or each of the features described with regard to the second aspect.

### Brief Description of the Figures

Various features and advantages of the invention will be set forth in part in the following description of Figures referring to various examples of the invention. In this context it is noted that the dimensions shown in all Figures of this disclosure are not to scale. The illustrations are simplified and not in each Figure all components are indicated with reference numerals and like reference numerals may be carried forward. In this description, reference is made to the accompanying Figures, in which:
Fig. 1 is a schematic perspective view of a first exemplary embodiment of a solar cell structure;
Fig. 2 is a schematic perspective view of a second exemplary embodiment of a solar cell structure;
Fig. 3 is a flow diagram showing the steps for assembling the first exemplary embodiment of the solar cell structure as shown in Fig. 1;
Fig. 4 is a flow diagram showing the steps for assembling the second exemplary embodiment of the solar cell structure as shown in Fig. 2;
Fig. 5 is a schematic perspective view of a third exemplary embodiment of a solar cell structure; and
Fig. 6 is a flow diagram showing the steps for assembling the third exemplary embodiment of the solar cell structure as shown in Fig. 5.

### Detailed Description

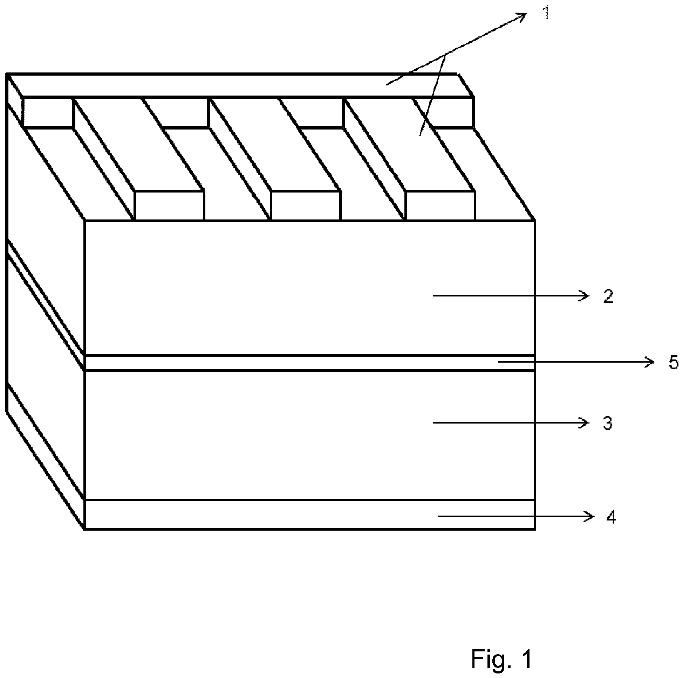

Fig. 1 is a schematic perspective view of a first exemplary embodiment of a solar cell structure according to the present invention. The solar cell structure includes a stack of components including a first electrode 1, a first semiconductor layer 2, a second semiconductor layer 3, a second electrode 4, and a first transparent conductive layer 5. The first electrode 1 may be considered the negative electrode, and the second electrode 4 may be considered the positive electrode. Furthermore, the first semiconductor layer 2 may be considered the electron donor, such as an n-type semiconductor material, and the second semiconductor layer 3 may be considered the electron acceptor, such as a p-type semiconductor material. In use, photons impinging on the solar cell will generate a current and a potential difference between the first electrode 1 and the second electrode 4.

The first electrode 1 abuts, and is in electrical contact with, the first semiconductor layer 2 on an upper surface of the first semiconductor layer 2. The first electrode 1 comprises several conductive tracks each extending across a width of the first semiconductor layer 2. Each of the conductive tracks are attached, at one end thereof, to a bushbar. Accordingly, sunlight may impinge on the first semiconductor layer between the conductive tracks, and the conductive tracks and bushbar may collect current generated via the photovoltaic effect. Although only three conductive tracks and a single bushbar are shown, any number may be provided. The overall surface area of the first electrode 1 presented to the sun may be minimised to increase the number of photons that impinge on the first semiconductor layer 2. In case the first electrode 1 is made of transparent material, the photons may also pass the areas covered by the fingers and tracks of the first electrode. The second electrode 4 is the rear electrode and may therefore be a continuous planar element as shown in Fig. 1.

The boundary layer between the first semiconductor layer 2 and second semiconductor 3 is physically separated by a first transparent conductive layer 5. As discussed herein, separating the boundary layer in this way has been found to decrease degradation and increase efficiency of the solar cell. Optical transparency may be achieved when at least 20 % of photons pass through the transparent conductive layer 5. Additionally, the transparent conductive layer 5 may have a conductivity of at least 10 000 S/m. has a conductivity of at least 11 000, 12 000, 13 000, 14 000, 15 000, 20 000, 25 000 or 30 000 S/m. Other, potentially more preferable, values can be envisaged as long as the efficiency is improved and degradation over time is lower than in common solar cells without such separating conductive layer.

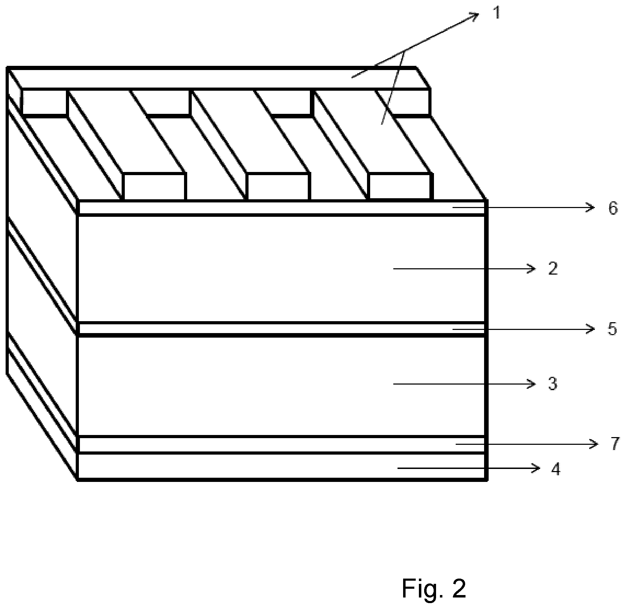

Fig. 2 is a schematic perspective view of a second exemplary embodiment of a solar cell structure. The second exemplary embodiment of the solar cell structure is similar to the first exemplary embodiment of the solar cell structure as shown in Fig.1, although it also includes a second transparent conductive layer 6 and a third transparent conductive layer 7. The second 6 and third 7 transparent conductive layers may be identical to the first transparent conductive layer 5. Alternatively, the transparent conductive layers 5, 6, 7 may each have different transparency and conductivity properties and/or different thicknesses. Physically separating the first electrode 1 from the first semiconductor layer 2, and the second electrode 4 from the second semiconductor layer 3, with second 6 and third 7 transparent conductive layers has been found to further decrease degradation and increase efficiency of the solar cell. Accordingly, a more preferably solar cell may be provided.

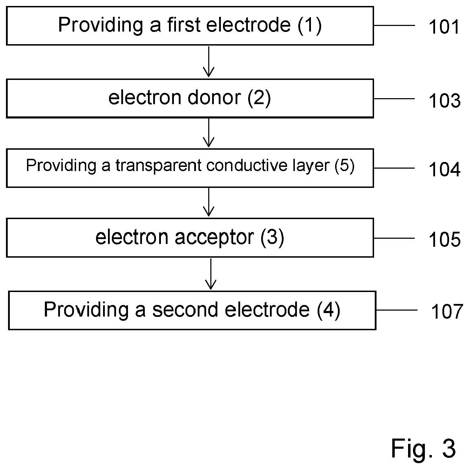

Fig. 3 is a flow diagram showing the steps for assembling the first exemplary embodiment of the solar cell structure as shown in Fig. 1. The first step is to provide 101 the first electrode 1. The next step is to form 103 the electron donor semiconductor layer 2 on the first electrode. Following this, the next step is to form 104 the transparent conductive layer 5 on the semiconductor layer 2 to cover a surface of the semiconductor layer 2 that is opposite to the first electrode 1. The fourth step is to form 105 the electron acceptor semiconductor layer on the transparent conductive layer 5 such that the transparent conductive layer 5 physically separates the electron donor semiconductor layer 2 from the electron acceptor semiconductor layer 3. The final step is to provide 107 the second electrode 4 on a surface of the electron acceptor semiconductor layer 3 that is opposite to the transparent conductive layer 5.

In some embodiments, the electrodes (see reference signs 1 and 4 e.g. in Figure 1 as well as method steps 101 and 102 in Fig. 3) and transparent conductive layer may be prefabricated and attached to the respective semiconductor layer. In some embodiments, the semiconductor layers are formed via an additive manufacturing process such as CVD, PVD, a galvanic procedure or a sol-gel process.

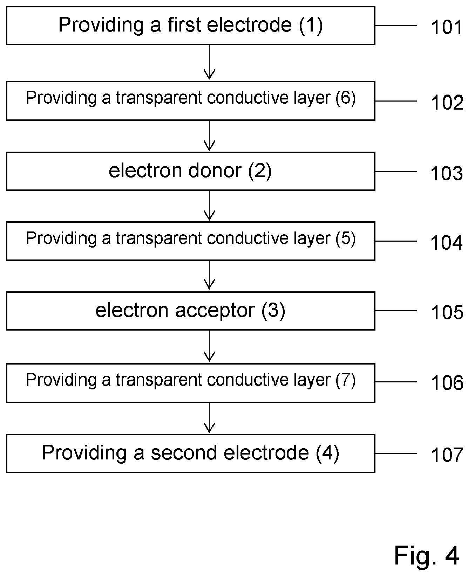

Fig. 4 is a flow diagram showing the steps for assembling the second exemplary embodiment of solar cell structure as shown in Fig. 2. The process for assembling second exemplary embodiment of the solar cell structure is similar to the process for assembling the first solar cell structure, as shown in Fig. 3, with two additional steps.

Prior to the forming 103 of the electron donor semiconductor layer 2, a second transparent conductive layer 6 is provided 102 to physically separate the first electrode 1 and the electron donor semiconductor layer 2. Furthermore, following the forming 105 of the electron acceptor semiconductor layer 3, a third transparent conductive layer 7 is provided 106 to physically separate the second electrode 4 and the electron acceptor semiconductor layer 3.

In this way the solar cell comprising three transparent conductive layers is produced, which is configured to provide particularly beneficial and advantageous efficiency and degradation properties.

Alternatively to the second exemplary embodiment, a further exemplary embodiment (not shown) can be provided, which besides the first transparent conductive layer 5 only comprises one additional transparent conductive layer (e.g. layer 6) can be provided.

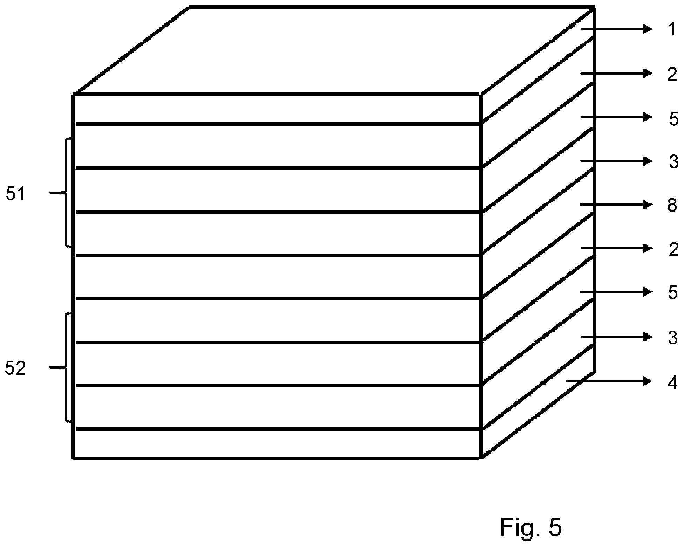

Fig. 5 is a schematic perspective view of a third exemplary embodiment of a solar cell structure. The solar cell structure comprises a stack of layers including, from top to bottom, a first electrode 1, an electron donor 2, a first transparent conductive layer 5, an electron acceptor 3, a tunnel junction 8, a further electron donor 2, a further first transparent conductive layer 5, a further electron accept 3, and a second electrode 4. Forming a solar cell structure in this way generally provides a multi-junction solar cell with a first solar cell 51 stacked on top of and separated from a second solar cell 52 by a tunnel junction 8. Third, fourth, or any other number of solar cells (not shown) may also be stacked in this way, with tunnel junctions 8 provided between the solar cells. The individual solar cells 51, 52 may be connected in series via the tunnel junctions 8, otherwise known as tunnel diodes. As with conventional solar cells, multi-junction solar cells, such as that shown in Fig. 5, have two external contacts.

The individually layered solar cells 51, 52 may consist of different materials that are tailored or specialise in specific spectra of sunlight. Accordingly, the first solar cell 51 may operate via a first spectra of sunlight and the second solar cell 52 may operate via a second spectra of sunlight, distinct from the first spectra of sunlight, to convert a larger portion of the sunlight into useful energy. As the first solar cell 51 is transparent, the second spectra of sunlight may pass there through to the second solar cell 52.

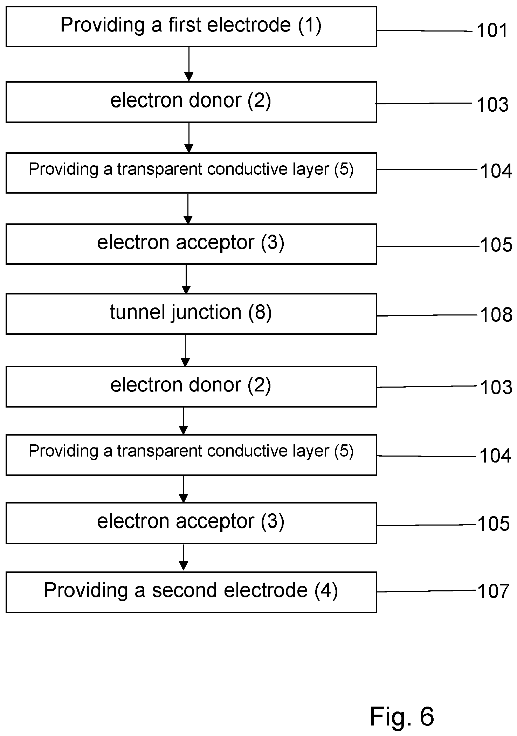

Fig. 6 is a flow diagram showing the steps for assembling the third exemplary embodiment of the solar cell structure as shown in Fig. 5. In principle, multi-junction solar cells may be manufactured in two processes. In multi-terminal structures, the p-n junctions are mechanically stacked with separate, sometimes transparent, contacts. Here, the materials are separated from each other. In monolithic structures, such as shown in Fig.5, the multi-junctions solar cell consists of substrates that are connected to each other via tunnel diodes.

The first step is to provide 101 the first electrode 1. The next step is to form 103 the electron donor semiconductor layer 2 on the first electrode. Following this, the next step is to form 104 the transparent conductive layer 5 on the semiconductor layer 2 to cover a surface of the semiconductor layer 2 that is opposite to the first electrode 1. The fourth step is to form 105 the electron acceptor semiconductor layer on the transparent conductive layer 5 such that the transparent conductive layer 5 physically separates the electron donor semiconductor layer 2 from the electron acceptor semiconductor layer 3. The next step is to form 108 a tunnel junction 8 on a surface of the electron acceptor 3 opposite to the transparent conductive layer 5. The steps of forming 103 the electron donor 2, providing 104 a transparent conductive layer 5, and forming 105 the electron acceptor 3 are repeated to form a second solar cell. The final step is to provide 107 the second electrode 4 on a surface of the electron acceptor semiconductor layer 3 that is opposite to the transparent conductive layer 5.

Prior to the provision 107 of the second electrode 4, further solar cells may be formed and separated from the adjacent solar cell by a tunnel junction 8. As will be apparent from the present disclosure, further transparent conductive layers may be provided between the first electrode 1 and the electron donor 2, and between the electron acceptor 3 and the second electrode 4. Each layer of electron donor 2 and coupled electron acceptor 3 may comprise different materials to each other layer of electron donor 2 and electron acceptor 3, to operate via different spectra of sunlight to other donor/acceptor pairs in the stack.

In this context it is noted that the dimensions shown in all Figures of this disclosure are not to scale. The illustrations are simplified. Use of ordinal terms such as "first", "second", "third", and the like in the claims to modify a claim element does not by itself connote any priority, precedence, or order of one claim element over another, but are used merely as labels to distinguish one claim element having a certain name from another element having a same name (but for use of the ordinal term) to distinguish the claim elements. It is noted that the terms "upper" and "lower" used herein are intended not to be limiting. That is to say that spatially relative terms "upper" and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. Individual elements or features of a particular embodiment are generally not limited to that particular embodiment, but, where applicable, are interchangeable and can be used in a selected embodiment, even if not specifically shown or described.

### Reference List

- 1: - first electrode
- 2: - electron donor
- 3: - electron acceptor
- 4: - second electrode
- 5: - first transparent conductive layer
- 6: - second transparent conductive layer
- 7: - third transparent conductive layer
- 8: - tunnel junction
- 51: - first cell
- 52: - second cell
- 101: - step of providing the first electrode (1)
- 102: - step of providing the second transparent conductive layer (6)
- 103: - step of providing the electron donor (2)
- 104: - step of providing the first transparent conductive later (5)
- 105: - step of providing the electron acceptor (3)
- 106: - step of providing the third transparent conductive layer (7)
- 107: - step of providing the second electrode (4)
- 107: - step of providing the tunnel junction (8)

## Claims

1. A solar cell structure comprising,
a first semiconductor layer (2) of a first dopant type in electrical communication with a first electrode (1);
a second semiconductor layer (3) of a second dopant type in electrical communication with a second electrode (4);
**characterized in that**
between the first semiconductor layer (2) and second semiconductor layer (3) a transparent conductive layer (5) is positioned.

2. A solar cell structure of claim 1, wherein the transparent conductive layer (5) is configured such that 20 % to 100 % of the incoming photons pass through said conductive layer (5).

3. A solar cell wherein resistivity of claim 1 or 2, wherein the conductive layer (5) has a conductivity of at least 10 000 S/m.

4. A solar cell of any of the preceding claims, wherein the conductive layer comprises one or more of the following materials selected from the group comprising:
Ag, Cu, Au, Al, W, Fe, Fe/C, conductive metal grids, metal nanowires graphite, graphene, carbon nanotubes, conductive polymers, preferably poly (3,4.ethylenedioxythipene) poly (styrenesulfonate) (PEDOT-PSS), conductive adhesives and conductive fluids and/or combination thereof.

5. A solar cell structure of any of the preceding claims, wherein the overall thickness of the conductive layer is at least 3 µm.

6. A solar cell structure of claim 5, wherein the thickness range is selected from the group comprising: 3-5 µm, 5-100 µm, 100-500 µm and 500-6000 µm.

7. A solar cell structure of any of the preceding claims, wherein the solar cell structure further comprises at least a further transparent conductive layer (6) between the first electrode and the first semiconductor layer and/or a further conductive layer (7) between the second electrode and the second semiconductor layer.

8. A solar cell structure of any of the preceding claims, wherein the transparent conductive layer (5, 6, 7) is a sandwich structure or functional thin layer made of a functional conductive layer supported by a carrier substrate made of glass, wafer or film.

9. A solar cell structure of any of the preceding claims, wherein the first and/or second semiconductor layers (2,3) are made of organic materials or inorganic materials selected from of the group comprising:
amorphous silicone (aSi);
polycrystalline silicon;
monocrystalline silicone;
pervoskite
cadmium telluride (CdTe);
copper indium gallium selenide (CIGS); and
an III-V semiconductor.

10. A solar cell structure of any of the preceding claims,
wherein the first dopant type of the semiconductor layer (2) is an n-type and the second dopant type of the second semiconductor layer (3) is a p-type.

11. A solar cell structure of any of the preceding claims,
wherein the solar cell and the conductive layer (7) is made of a flexible material.

12. A method of producing a solar cell comprising the steps of:
providing (101) a first electrode;
preparing (103) a semiconductor layer (2) of a first dopant type in electrical communication with the first electrode;
providing (104) a transparent conductive layer (5) on the surface of the first semiconductor layer (2), wherein the method of forming the conductive layer is selected from the group of additive processes comprising:
CVD, PVD, a galvanic procedure or a sol-gel process; and
forming (105) a second semiconductor layer (3) of a second dopant type on the transparent conductive layer (5); and;
electrically connecting (107) the second semiconductor layer (3) with a second electrode (4).

13. A method according to claim 12, wherein between the first electrode (1) and the first semiconductor layer (2) a further transparent conductive layer (6) is formed; and optionally, wherein between the second electrode (4) and the second semiconductor layer (7) a further transparent conductive layer is formed (106).

14. A method according to any of the claims 12 to 13, wherein the at least one transparent conductive layer (5, 6, 7) is produced by embedding conductive material in a polymer, wherein the conductive material is selected from the group comprising:
Ag, Cu, Au, Al, W, Fe, Fe/C, conductive metal grids, metal nanowires, graphite, graphene, carbon nanotubes and/or combination thereof.

15. A method according to any of the claims 12 to 14, wherein at least one transparent conductive layer (5, 6, 7) are made of a functional conductive layer supported by a carrier substrate made of glass, wafer or film

## Amended claims

### Amended claims in accordance with Rule 137(2) EPC.

1. A solar cell structure comprising,
a first semiconductor layer (2) of a first dopant type in electrical communication with a first electrode (1);
a second semiconductor layer (3) of a second dopant type in electrical communication with a second electrode (4);
**characterized in that**
between the first semiconductor layer (2) and second semiconductor layer (3) a transparent conductive layer (5) is positioned; which transparent conductive layer (5, 6, 7) comprises a carrier substrate and/ or is produced by embedding conductive material in a polymer.

2. A solar cell structure of claim 1, wherein the transparent conductive layer (5) is configured such that 20 % to 100 % of the incoming photons pass through said conductive layer (5).

3. A solar cell wherein resistivity of claim 1 or 2, wherein the conductive layer (5) has a conductivity of at least 10 000 S/m.

4. A solar cell of any of the preceding claims, wherein the conductive layer comprises one or more of the following materials selected from the group comprising:
Ag, Cu, Au, Al, W, Fe, Fe/C, conductive metal grids, metal nanowires graphite, graphene, carbon nanotubes, conductive polymers, preferably poly (3,4.ethylenedioxythipene) poly (styrenesulfonate) (PEDOT-PSS), conductive adhesives and conductive fluids and/or combination thereof.

5. A solar cell structure of any of the preceding claims, wherein the overall thickness of the conductive layer is at least 3 µm.

6. A solar cell structure of claim 5 wherein the thickness range is selected from the group comprising: 3-5µm, 5-100 µm and 100-500µm.

7. A solar cell structure of any of the preceding claims, wherein the solar cell structure further comprises at least a further transparent conductive layer (6) between the first electrode and the first semiconductor layer and/or a further conductive layer (7) between the second electrode and the second semiconductor layer.

8. A solar cell structure of any of the preceding claims, wherein the the carrier substrate is transparent or translucent and made of glass, wafer or film.

9. A solar cell structure of any of the preceding claims, wherein the first and second semiconductor layers (2,3) are made of anorganic materials selected from the group comprising:
armorphous silicone (aSi);
polycrystalline silicon;
monocrystalline silicone;
cadmium telluride (CdTe); and
copper indium gallium selenide (CIGS).

10. A solar cell structure of any of the preceding claims,
wherein the first dopant type of the semiconductor layer (2) is a n-type and the second dopant type of the second semiconductor layer (3) is a p-type.

11. A method of producing a solar cell comprising the steps of:
providing (101) a first electrode;
preparing (103) a semiconductor layer (2) of a first dopant type in electrical communication with the first electrode;
providing (104) a transparent conductive layer (5) on the surface of the first semiconductor layer (2), wherein the method of forming the conductive layer is selected from the group of additive processes comprising:
CVS, PVD, a galvanic procedure or a sol-gel process; and
forming (105) a second semiconductor layer (3) of a second dopant type on the transparent conductive layer (5); and;
electrically connecting (107) the second semiconductor layer (3) with a second electrode (4); wherein the at least one transparent conductive layer (5, 6 7) is made of a functional conductive layer comprising a carrier substrate and/or is produced by embedding conductive material in a polymer.

12. A method according to claim 11, wherein between the first electrode (1) and the first semiconductor layer (2) a further transparent conductive layer (6) is formed.

13. A method according to claim 11 or 12, wherein between the second electrode (4) and the second semiconductor layer (7) a further transparent conductive layer is formed (106).

14. A method according to any of the claims 11 to 13, wherein the conductive material is selected from the group comprising:
Ag, Cu, Au, Al, W, Fe, Fe/C, conductive metal grids, metal nanowires, graphite, graphene, carbon nanotubes and/or combination thereof.

15. A method according to any of the claims 11 to 14, wherein the carrier substrate is transparent or translucent and made of glass, wafer or film.
